# EUROPÄISCHE PATENTANMELDUNG

(11) **EP 2 249 409 A2**
(43) Veröffentlichungstag der Anmeldung: **10.11.2010**
(21) Anmeldenummer: 10156712.1
(22) Anmeldetag: 17.03.2010
(51) Int. Cl.: H01L 41/187, H01L 41/083, F02M 51/06

(54) **Piezokeramik für Aktoren**

(30) Priorität: 06.05.2009 DE 102009002835
(71) Anmelder: Robert Bosch GmbH, 70442 Stuttgart (DE)
(72) Erfinder: Cromme, Peter, 96050, Bamberg (DE)

(57) **Zusammenfassung**

Es wird eine Piezokeramik (46) mit einer aus einem Ausgangsmaterial erzeugten Kristallstruktur (40) beschrieben, welche einen intrakristallinen Bruchmodus aufweist, der durch Erhöhung der Kongrenzfestigkeit, beispielsweise mittels Bildung eines intergranularen Nanokomposits, erzeugt werden kann. Ferner wird ein Piezoaktor (50) für ein Piezoaktormodul (3) beschrieben, bestehend aus einem aktiven Bereich (51) mit Piezoelementen (53) aus Piezolagen (54) mit dazwischen angeordneten Innenelektroden (55) sowie zumindest einem sich an die Piezoelemente (53) des aktiven Bereichs (51) anschließenden passiven Bereich (52) aus Piezolagen (56), die frei von Innenelektroden (55) sind, bei dem zumindest die an den aktiven Bereich (51) angrenzenden Piezolagen (56) des passiven Bereichs (52) aus einer Piezokeramik (46) bestehen, welche einen intrakristallinen Bruchmodus aufweist. Darüber hinaus wird ein Piezoaktormodul (3) mit einem Aktorfuß (5) und einem Aktorkopf (4) und mindestens einem dazwischen eingefassten Piezoaktor (50) beschrieben.

## Beschreibung

### Stand der Technik

Die Erfindung betrifft eine Piezokeramik als Piezolage für einen Piezoaktor oder ein Piezoaktormodul nach den gattungsgemäßen Merkmalen des Anspruchs 1, einen Piezoaktor für ein Piezoaktormodul nach den gattungsgemäßen Merkmalen des Anspruchs 10, ein Piezoaktormodul mit einem solchen Piezoaktor nach den gattungsgemäßen Merkmalen des Anspruchs 15, sowie einen Piezoinjektor nach den gattungsgemäßen Merkmalen des Anspruchs 16.

Es ist an sich bekannt, dass zum Aufbau eines zuvor erwähnten Piezoaktors Piezoelemente so eingesetzt werden, dass unter Ausnutzung des sogenannten Piezoeffekts eine Steuerung des Nadelhubs eines Ventils oder dergleichen vorgenommen werden kann. Die Piezoelemente sind aus Piezolagen bestehend aus einer Piezokeramik mit einer beispielsweise durch Sintern und/oder Kalzinieren eines Ausgangsmaterials erzeugten geeigneten Kristallstruktur so aufgebaut, dass bei Anlage einer äußeren elektrischen Spannung an Innenelektroden, die die Piezolagen jeweils einschließen, eine mechanische Reaktion der Piezoelemente erfolgt.

Ein Piezoaktor besteht dabei aus einem oder mehreren an ihren Stirnflächen miteinander typischerweise durch Laminieren miteinander verbundenen Piezoelementen sowie aus entlang dem Piezoelement verlaufenden Außenelektroden zur elektrischen Kontaktierung der Innenelektroden.

In Abhängigkeit von der Kristallstruktur und der Anlagebereiche der elektrischen Spannung stellt die mechanische Reaktion einen Druck oder Zug in eine vorgebbare Richtung dar. Derartige Piezoaktoren eignen sich beispielsweise für Anwendungen, bei denen Hubbewegungen unter hohen Betätigungskräften und hohen Taktfrequenzen ablaufen.

Piezoaktoren werden beispielsweise in Piezoinjektoren eingesetzt, welche zur zeitpunkt- und mengengenauen Dosierung von Kraftstoff in periodisch arbeitenden Verbrennungsmotoren verwendet werden.

Ein Piezoinjektor besteht im Wesentlichen aus einem Haltekörper und einem in dem Haltekörper unter einer Druckvorspannung angeordneten Piezoaktormodul, bestehend aus einem Kopf- und einem Fußteil sowie einem zwischen Kopf- und Fußteil angeordneten Piezoaktor aus einem oder mehreren Piezoelementen. Das Kopfteil des Piezoaktormoduls ist mit einer Düsennadel verbunden, sodass durch Anlegen oder Wegnahme einer Spannung an die Piezoelemente eine Düsenöffnung freigegeben oder verschlossen wird. Das auch als Aktorkopf und Aktorfuß bezeichnete Kopf- und Fußteil sind an gegenüberliegenden Stirnflächen des Piezoaktors angeordnet.

Solche Piezoinjektoren sind beispielsweise aus der DE 103 53 169 A1, aus der DE 10 2006 045 663 A1 und aus der DE 10 2007 047 426 A1 bekannt.

Piezoaktoren nach dem Stand der Technik weisen typischerweise ein auch als interdigital bezeichnetes alternierendes Innenelektrodendesign mit einer einheitlichen Schichtdicke der Piezolagen über den gesamten, aus den Piezoelementen umfassend die durch Innenelektroden umschlossenen Piezolagen bestehenden aktiven Bereich auf, an den sich an ihren den Fuß- und Kopfteilen des Piezoaktormoduls zugewandten Enden fußseitig und kopfseitig ein inaktiver bzw. passiver Bereich bestehend aus Piezolagen ohne Innenelektroden anschließt. Als passiver Bereich wird hierbei der Bereich ohne Innenelektroden bezeichnet. Ein inaktiver Bereiche weist dagegen Innenelektroden mit einer einheitlichen Polarität auf. Solche Piezoaktor können dabei sowohl einen inaktiven als auch einen passiven als auch nur einen passiven Bereich aufweisen.

Piezoaktoren mit interdigitalem Innenelektrodendesign sind insbesondere an den Übergängen zwischen den aktiven und passiven Bereichen im Fuß- und Kopfbereich anfällig gegen Rissbildung. Besonders kritisch sind hier Risse in Aktorlängsrichtung. Die Anfälligkeit hinsichtlich Rissbildung kann im Wesentlichen auf zwei Ursachen reduziert werden. Die eine Ursache ist auf den abrupten Übergang von aktiven auf inaktive bzw. passive Piezolagen zurückzuführen. Die andere Ursache ist auf eine beispielsweise durch unterschiedliche Dotierstoffe oder durch unterschiedliche Dotierstoffkonzentrationen verursachte diskontinuierliche Materialzusammensetzung der für die der Piezolagen in den aktiven und inaktiven Bereichen verwendeten Piezokeramik, beispielsweise aus Blei-Zirkonat-Titanat (PZT), zurückzuführen.

Die zur Herstellung von Piezolagen z. B. für Piezoaktoren heutzutage verwendeten Piezokeramiken zeigen hierbei das durch interkristallinen Bruchmodus hervorgerufene oben beschriebene Rissverhalten. Derartige Piezokeramiken bzw. Verfahren zu deren Herstellung sind beispielsweise durch die DE 28 37 508 C3, durch die DE 34 44 177 A1, durch die DE 198 40 488 A1 und durch die DE 10 2005 014 765 B4 bekannt.

Bisherige Lösungsansätze zur Verringerung der Anfälligkeit gegen Rissbildung schlagen hauptsächlich eine Verringerung der elektrischen Feldbelastung und eine Homogenisierung der Materialzusammensetzung der Piezolagen an den Übergängen zwischen den aktiven und den passiven Bereichen durch eine Erhöhung der Dielektrikumdicke in diesen Bereichen vor. Nachteilig hieran ist, dass durch diese Maßnahmen eine Designänderung des Piezoaktors notwendig ist. Ein weiterer Nachteil hieran ist, dass zusätzlich der Aktorhub bei konstanter Aktorlänge empfindlich reduziert wird. In der Praxis bedeutet dies, dass entweder bei gegebenem Bauraum ein nur geringerer Aktorhub erzielt werden kann, oder bei beispielsweise durch technische Gegebenheiten erforderlichem vorgegebenem Aktorhub mehr Bauraum benötigt wird.

### Offenbarung der Erfindung

Ein erster Gegenstand der Erfindung geht aus von einer Piezokeramik mit einer beispielsweise durch Sintern und/oder Kalzinieren aus einem Ausgangsmaterial erzeugten Kristallstruktur. Die erfindungsgemäße Piezokeramik zeichnet sich durch einen intrakristallinen Bruchmodus aus.

Sich hieraus ergebende Vorteile gegenüber dem Stand der Technik sind, dass durch die Änderung des Bruchmodus weg von einem interkristallinen Bruchmodus hin zu einem intrakristallinen Bruchmodus sowohl die Festigkeit als auch die Zähigkeit der Piezokeramik bei aufgrund desselben verwendeten Ausgangsmaterials sonst gleich bleibenden Materialeigenschaften steigt.

Der intrakristalline Bruchmodus kann beispielsweise durch eine gezielte Erhöhung der Korngrenzfestigkeit bzw. durch eine gegenüber einer Piezokeramik mit interkristallinem Bruchmodus erhöhte Korngrenzfestigkeit erzeugt bzw. hergestellt sein. Vorzugsweise ist die Korngrenzfestigkeit durch Bildung eines intergranularen Nanokomposits erhöht.

Das intergranulare Nanokomposit kann beispielsweise durch Einbringen inerter Nanopartikel bzw. Fein- oder Feinstpartikel in das Ausgangsmaterial der Piezokeramik vor dem Sintern und/oder Kalzinieren gebildet sein. Dadurch entsteht ein modifiziertes Piezokeramik-Material, das die gewünschten Eigenschaften eines intrakristallinen Bruchmodus aufweist.

Die Menge der vor dem Sintern und/oder Kalzinieren in das Ausgangsmaterial eingebrachten inerten Nanopartikel bzw. Fein- oder Feinstpartikel ist vorzugsweise derart gering bemessen, dass sich die makroskopischen Material- und elektromechanischen Eigenschaften der Piezokeramik mit intrakristallinem Bruchmodus nicht von denen einer aus demselben Ausgangsmaterial hergestellten Piezokeramik, insbesondere solcher mit interkristallinem Bruchmodus, unterscheiden.

Zur Bildung des intergranularen Nanokomposits können beispielsweise inerte oxidische und/oder carbidische und/oder nitridische Nanopartikel in das Ausgangsmaterial eingebracht werden, die unter den Sinter- und/oder Kalzinierbedingungen des zur Herstellung der Piezokeramik verwendeten Ausgangsmaterials stabil sind.

Besonders bevorzugt bestehen die zur Herstellung des intergranularen Nanokomposits in das Ausgangsmaterial eingebrachten inerten Nanopartikel aus Platin (Pt) und/oder aus Magnesiumoxid (MgO) und/oder aus Siliziumcarbid (SiC).

Eine besonders vorteilhafte Ausgestaltung der erfindungsgemäßen Piezokeramik sieht vor, dass das Ausgangsmaterial zumindest die zur Herstellung einer PZT-Piezokeramik erforderlichen, beispielsweise oxidischen Ausgangsverbindungen, bzw. eine Mischung dieser Ausgangsverbindungen umfasst.

Ein zweiter Gegenstand der Erfindung betrifft eine Piezolage aus einer zuvor beschriebenen erfindungsgemäßen Piezokeramik. Die Piezolage nutzt die gegenüber dem Stand der Technik verbesserten elektromechanischen Eigenschaften der Piezokeramik insbesondere im Hinblick auf Rissbildung und -ausbreitung.

Ein dritter Gegenstand der Erfindung geht aus von einem Piezoaktor für ein Piezoaktormodul. Der Piezoaktor besteht aus einem sich in Richtung einer Längsachse des Piezoaktors erstreckenden aktiven Bereich mit Piezoelementen aus Piezolagen mit dazwischen angeordneten Innenelektroden sowie zumindest einem sich in Richtung der Längsachse des Piezoaktors an die Piezoelemente des aktiven Bereichs anschließenden passiven Bereich aus Piezolagen, die frei von Innenelektroden sind. Bei dem erfindungsgemäßen Piezoaktor bestehen zumindest die an den aktiven Bereich angrenzenden Piezolagen des passiven Bereichs aus einer zuvor beschriebenen Piezokeramik, welche einen intrakristallinen Bruchmodus aufweist.

Wesentlicher Gedanke der Erfindung hierbei ist eine Steigerung der Aktorrobustheit durch Änderung des Bruchmodus der für die Piezolagen verwendeten Piezokeramik von einem interkristallinen Bruchmodus, wie ihn die Piezokeramiken nach dem Stand der Technik aufweisen, hin zu einem intrakristallinen Bruchmodus zumindest in den mechanisch hoch beanspruchten Übergängen zwischen den aktiven und passiven Bereichen des Piezoaktors. Durch die Änderung des Bruchmodus steigt sowohl die Festigkeit als auch die Zähigkeit des für die Piezokeramik verwendeten Materials, insbesondere PZT-Materials, bei sonst gleichen Materialeigenschaften.

Die Erfindung ermöglicht es dadurch, den Piezoaktor robuster zu gestalten, ohne das Design bzw. die Auslegung und die elektromechanischen Eigenschaften eines Piezoaktors zu verändern.

Vorzugsweise schließen sich bei dem erfindungsgemäßen Piezoaktor in Richtung dessen Längsachse beidseitig der Piezoelemente des aktiven Bereichs passive Bereiche aus Piezolagen bestehend aus der Piezokeramik mit intrakristallinem Bruchmodus an.

Zusätzlich können zumindest die an den passiven Bereich angrenzenden Piezolagen der Piezoelemente des aktiven Bereichs aus der Piezokeramik mit intrakristallinem Bruchmodus bestehen.

Ebenso ist denkbar, dass sämtliche Piezolagen des Piezoaktors aus der Piezokeramik mit intrakristallinem Bruchmodus bestehen.

Alternativ können die verbleibenden Piezolagen des Piezoaktors aus einer aus demselben Ausgangsmaterial hergestellten Piezokeramik wie die Piezokeramik mit intrakristallinem Bruchmodus bestehen.

Ein vierter Gegenstand der Erfindung betrifft ein Piezoaktormodul mit einem Aktorfuß und einem Aktorkopf und mindestens einem dazwischen eingefassten Piezoaktor. Bei dem Piezoaktor handelt es sich um einen oben beschriebenen erfindungsgemäßen Piezoaktor.

Ein fünfter Gegenstand der Erfindung betrifft einen Piezoinjektor mit einem Haltekörper und einem in dem Haltekörper angeordneten Piezoaktormodul. Bei dem Piezoaktormodul handelt es sich um ein zuvor beschriebenes erfindungsgemäßes Piezoaktormodul.

Sowohl das erfindungsgemäße Piezoaktormodul, als auch der erfindungsgemäße Piezoinjektor erlauben es, die Vorteile des erfindungsgemäßen Piezoaktors zu nutzen.

### Kurze Beschreibung der Zeichnung

Ein Ausführungsbeispiel der Erfindung ist in der Zeichnung dargestellt und im Folgenden näher beschrieben. Es zeigen:
- Fig.: 1 eine schematische Darstellung eines Piezoinjektors nach dem Stand der Technik in einem Längsschnitt.
- Fig. 2: eine schematische Darstellung des kristallinen Aufbaus einer für Piezolagen verwendeten PZT Piezokeramik nach dem Stand der Technik, in Fig. 2A) in einem unbeschädigten Zustand und in Fig. 2B) in einem durch interkristalline Rissbildung beschädigten Zustand.
- Fig. 3: eine schematische Darstellung der Kristallstruktur einer für Piezolagen verwendeten Piezokeramik gemäß der Erfindung, in Fig. 3A) in einem unbeschädigten Zustand und in Fig. 3B) in einem durch intrakristallinen Bruchmodus beschädigten Zustand.
- Fig. 4: eine schematische Darstellung eines erfindungsgemäßen Piezoaktors in einem Längsschnitt in Fig. 4A), mit in Fig. 4B) und Fig. 4C) vergrößert dargestelltem Kopf- bzw. Fußbereich.

### Weg zu Ausführung der Erfindung

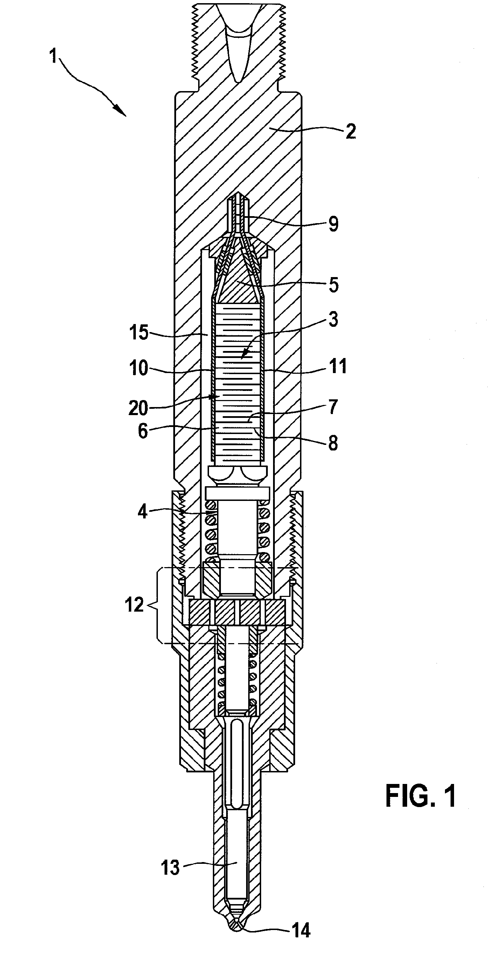

Ein in Fig. 1 dargestellter Piezoinjektor 1 umfasst im Wesentlichen einen Haltekörper 2 und einen in dem Haltekörper 2 angeordnetes Piezoaktormodul 3, das unter anderem einen Aktorkopf 4 und einen Aktorfuß 5 aufweist. Es sind dabei zwischen dem Aktorkopf 4 und dem Aktorfuß 5 mehrere übereinander gestapelte Piezoelemente 6 vorhanden, die jeweils aus Piezolagen aus Piezokeramik und diese einschließende Innenelektroden 7 und 8 bestehen. Zwischen den Piezoelementen 6 und dem Aktorkopf 4 sowie zwischen den Piezoelementen 6 und dem Aktorfuß 5 befinden sich nicht dargestellte Piezolagen, die frei von Innenelektroden sind. Diese bilden gemeinsam mit den Piezoelementen 6 den eigentlichen Piezoaktor 20. Die Piezoelemente 6 bilden dabei den aktiven Bereich des Piezoaktors 20, wohingegen die sich beidseitig an den aktiven Bereich anschließenden Piezolagen, die frei von Innenelektroden sind, die inaktiven bzw. passiven Bereiche des Piezoaktors 20 bilden.

Die Innenelektroden 7 und 8 der Piezoelemente 6 sind mit Außenelektroden 10 und 11 und dann über ein Steckerteil 9 elektrisch kontaktiert. Das Piezoaktormodul 3 ist über einen Koppler 12 mit einer Düsennadel 13 verbunden. Durch Anlegen einer Spannung an die Piezoelemente 6 über die Innenelektroden 7 und 8 und die daraus folgende mechanische Reaktion wird, wie in der Beschreibungseinleitung erläutert, eine Düsenöffnung 14 freigegeben. Das Piezoaktormodul 3 wird bei der dargestellten Anwendung nach Fig. 1 als Piezoinjektor 1 in einem Raum 15 von einem mit dem Piezoinjektor 1 zu dosierenden Medium, typischerweise einem Kraftstoff für einen Verbrennungsmotor umströmt.

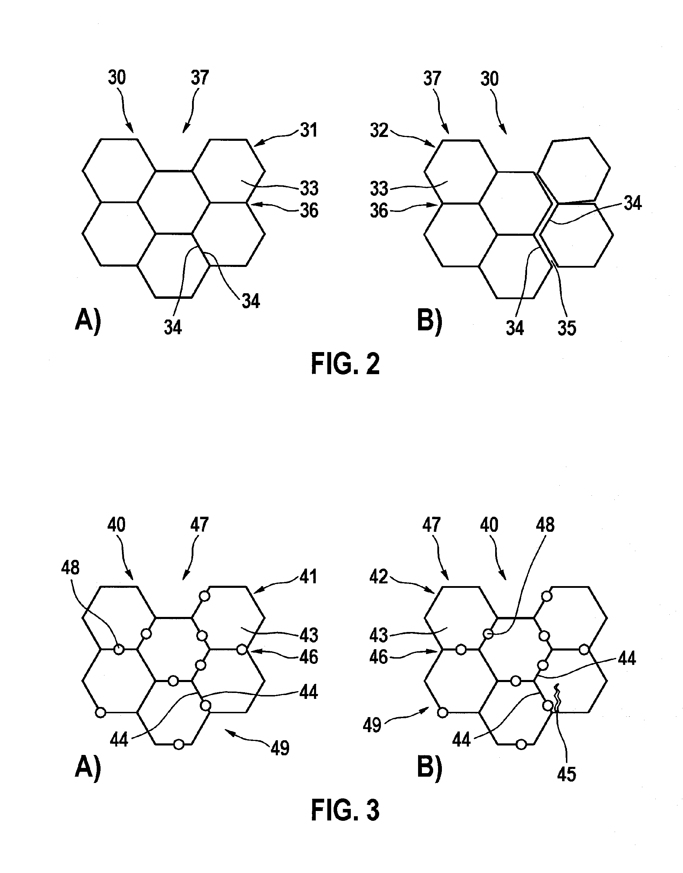

In Fig. 2 ist die Kristallstruktur 30 einer für Piezolagen verwendeten PZT Piezokeramik 36 nach dem Stand der Technik schematisch dargestellt. Die Kristallstruktur 30 zeigt ein Gefüge 37 aus einzelnen Kristallen 33. Die PZT-Piezokeramik 36 weist einen interkristallinen Bruchmodus auf. Fig. 2A) zeigt dabei einen unbeschädigten Zustand 31 der Kristallstruktur 30, in welchem unbeschädigten Zustand 31 die Kristalle 33 des Gefüges 37 an ihren Korngrenzen 34 aneinander anliegen. Fig. 2B) zeigt demgegenüber einen beschädigten Zustand 32 der Kristallstruktur 30, in welchem beschädigten Zustand 32 die Korngrenzen 34 einiger der Kristalle 33 des Gefüges 37 durch einen durch interkristallinen Bruchmodus hervorgerufenen Riss 35 nicht mehr aneinander anliegen. Es ist ersichtlich, dass der durch interkristallinen Bruchmodus hervorgerufene Riss 35 sich unaufhaltsam zwischen den Korngrenzen 34 innerhalb der Kristallstruktur 30 ausbreiten kann.

Fig. 3 zeigt demgegenüber schematisch die Kristallstruktur 40 einer für Piezolagen verwendeten erfindungsgemäßen Piezokeramik 46. Bei der Piezokeramik 46 handelt es sich um eine modifizierte Piezokeramik 46, deren Kristallstruktur 40 vorzugsweise durch Sintern und/oder Kalzinieren beispielsweise aus einem Ausgangsmaterial hergestellt ist, das zumindest die zur Herstellung einer PZT-Piezokeramik 36 erforderlichen Ausgangsverbindungen umfasst. Auch die Kristallstruktur 40 der modifizierten Piezokeramik 46 zeigt ein Gefüge 47 aus einzelnen Kristallen 43. Die modifizierte Piezokeramik 46 weist erfindungsgemäß einen intrakristallinen Bruchmodus auf. Fig. 3A) zeigt dabei einen unbeschädigten Zustand 41 der Kristallstruktur 40, wohingegen Fig. 3B) einen beschädigten Zustand 42 der Kristallstruktur 40 zeigt, welcher beschädigten Zustand 42 einen durch intrakristallinen Bruchmodus hervorgerufenen Riss 45 innerhalb eines Kristalls 49 erkennen lässt. Sowohl im unbeschädigten Zustand 41, als auch im beschädigten Zustand 42 der Kristallstruktur 40 der erfindungsgemäßen Piezokeramik 46 mit intrakristallinem Bruchmodus liegen die Kristalle 43 des Gefüges 47 an ihren Korngrenzen 44 aneinander an. Da die intrakristallinen Bindungskräfte der Kristalle 43 höher sind, als die interkristallinen Bindungskräfte zwischen den Kristallen 33 der Piezokeramik 36 aus Fig. 2, ist ersichtlich, dass die erfindungsgemäße Piezokeramik 46 einem Riss 45 weit mehr Widerstand entgegensetzt und damit weitaus widerstandsfähiger gegen Versagen ist, als dies die Piezokeramik 36 nach dem Stand der Technik gegenüber einem Riss 35 kann. Das Risswachstum ist demnach bei einer erfindungsgemäßen Piezokeramik 46 weitaus kleiner, als bei der Piezokeramik 36 nach dem Stand der Technik.

Ein intrakristalliner Bruchmodus kann beispielsweise ausgehend von einer PZT-Piezokeramik 36 nach dem Stand der Technik durch eine gezielte Erhöhung der Korngrenzenfestigkeit erreicht werden. Beispielsweise kann die Korngrenzenfestigkeit durch Bildung eines so genannten Intergranularen Nanokomposites 49 erhöht werden (Fig. 3). Bei einem Nanokomposit 49 werden erfindungsgemäß unter Sinterbedingungen inerte Fein- oder Feinstpartikel 48, sogenannte Nanopartikel 48, in das Ausgangsmaterial der Piezokeramik 46, beispielsweise in ein zumindest die zur Herstellung einer PZT-Piezokeramik 36 erforderlichen Ausgangsverbindungen umfassendes Ausgangsmaterial vor dem Sintern eingebracht. Die benötigten Mengen für ein Nanokomposit 49 sind vorzugsweise derartig gering, dass sich die makroskopischen Material- und elektromechanischen Eigenschaften nicht von einer PZT-Piezokeramik 36 nach dem Stand der Technik unterscheiden. Folgende Materialen sind aufgrund der hohen chemischen Beständigkeit als Nanopartikel 48 für die Herstellung eines Nanokomposites 49 geeignet: Platin (Pt), Magnesiumoxid (MgO), Siliziumcarbid (SiC), sowie alle weiteren oxidischen, carbidischen und nitridischen Nanopartikel 48, die unter den Sinterbedingungen zur Herstellung einer Kristallstruktur 40 aus dem Ausgangsmaterial stabil sind.

Wichtig ist hervorzuheben, dass die elektrische Leitfähigkeit von metallischem Platin (Pt) für eine Anwendung in Piezoaktoren keine Rolle spielt, da aufgrund der Partikelgröße und -verteilung der Nanopartikel 48 die elektrische Isolation zwischen den Elektroden des Piezoaktors gewährleistet wird.

Risse können sich in derartigen Nanokompositen 49 nicht mehr ungehindert an den Korngrenzen 44 zwischen den beispielsweise durch PZT-Körner gebildeten Kristallen 43 ausbreiten und verlaufen bevorzugt im Kristall 43 bzw. im PZT-Korn, d. h. intrakristallin. Dadurch steigt Materialfestigkeit und -Zähigkeit.

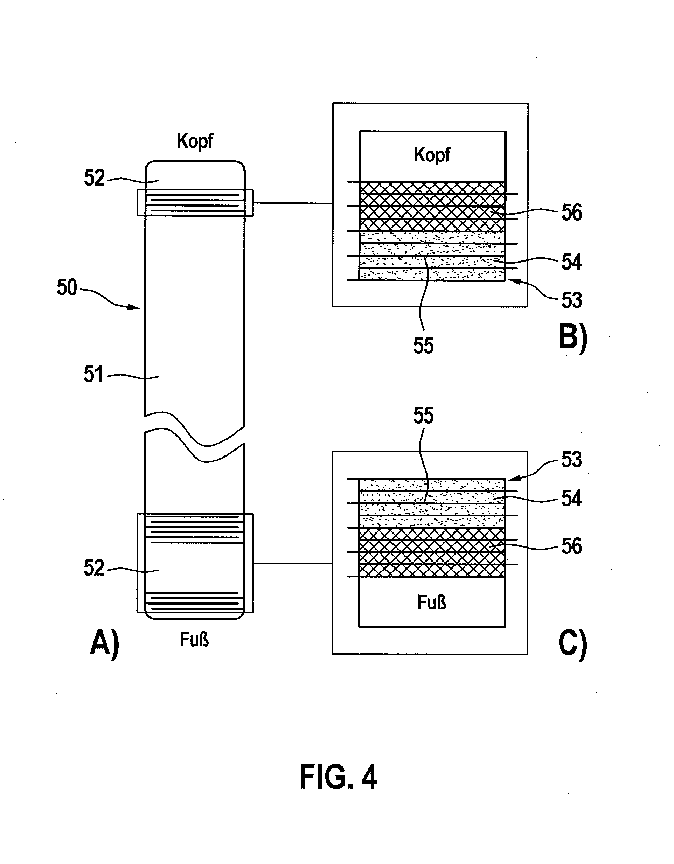

Ein erfindungsgemäßer Piezoaktor 50 für ein Piezoaktormodul bestehend aus einem aktiven Bereich 51 mit Piezoelementen 53 aus Piezolagen 54 mit dazwischen angeordneten Innenelektroden 55 sowie zumindest einem sich an die Piezoelemente 53 des aktiven Bereichs 51 anschließenden passiven Bereich 52 aus Piezolagen 56, die frei von Innenelektroden 55 sind, ist in Fig. 4 dargestellt. Bei diesem im Längsschnitt aus der Fig. 4A ersichtlichen Piezoaktor 50 bestehen zumindest die an den aktiven Bereich 51 angrenzenden Piezolagen 56 des passiven Bereichs 52 aus einer anhand der Fig. 3 beschriebenen Piezokeramik 46, welche einen intrakristallinen Bruchmodus aufweist.

Der Piezoaktor 50 mit aus einer solchen Piezokeramik 46 hergestellten Piezolagen 54, 56 mit und/oder ohne Innenelektroden 55 ist im Vergleich zum Stand der Technik robuster gegenüber Rissbildung und Risswachstum von bereits bestehenden Rissen, beispielsweise von verzweigenden Polungsrissen. Aus technischen und wirtschaftlichen Gesichtspunkten ist es sinnvoll, wie in den Fig. 4A) und B) vergrößert dargestellt, nur die im Piezoaktor 50 mechanisch besonders stark beanspruchten Piezolagen 56 im Übergang zwischen dem aktiven Bereich 51 und den passiven Bereichen 52 gemäß Fig. 4A) aus modifizierter Piezokeramik 46, vorzugsweise aus modifizierter PZT Piezokeramik herzustellen. Der hier schräg karierte Bereich weist intergranuläre Verstärkungspartikel auf; er besteht zum Beispiel aus PZT und Nanopartikel 48 (Fig. 3) als intergranuläre Verstärkungspartikel. Das Standard PZT-Material ist hier gepunktet angedeutet. Es ist aber auch möglich, den Piezoaktor 50 komplett aus Piezolagen aus modifizierter Piezokeramik 46 aufzubauen.

## Patentansprüche

1. Piezokeramik (46) mit einer aus einem Ausgangsmaterial erzeugten Kristallstruktur (40), **dadurch gekennzeichnet, dass** die Piezokeramik (46) einen intrakristallinen Bruchmodus aufweist.

2. Piezokeramik nach Anspruch 1, **dadurch gekennzeichnet, dass** der intrakristalline Bruchmodus durch eine Erhöhung der Korngrenzfestigkeit erzeugt ist.

3. Piezokeramik nach Anspruch 2, **dadurch gekennzeichnet, dass** die Korngrenzfestigkeit durch Bildung eines intergranularen Nanokomposits (49) erhöht ist.

4. Piezokeramik nach Anspruch 3, **dadurch gekennzeichnet, dass** das intergranulare Nanokomposit (49) durch Einbringen inerter Nanopartikel (48) in das Ausgangsmaterial vor dem Sintern und/oder Kalzinieren gebildet ist.

5. Piezokeramik nach Anspruch 4, **dadurch gekennzeichnet, dass** die Menge der vor dem Sintern und/oder Kalzinieren in das Ausgangsmaterial eingebrachten inerten Nanopartikel (48) derart gering ist, dass sich die makroskopischen Material- und elektromechanischen Eigenschaften der Piezokeramik (46) mit intrakristallinem Bruchmodus nicht von denen einer aus demselben Ausgangsmaterial hergestellten Piezokeramik (36) unterscheiden.

6. Piezokeramik nach Anspruch 3, 4 oder 5, **dadurch gekennzeichnet, dass** zur Bildung des intergranularen Nanokomposits (49) inerte oxidische und/oder carbidische und/oder nitridische Nanopartikel (48) in das Ausgangsmaterial eingebracht werden, die unter den Sinter- und/oder Kalzinierbedingungen des verwendeten Ausgangsmaterials stabil sind.

7. Piezokeramik nach einem der Ansprüche 4 bis 6, **dadurch gekennzeichnet, dass** die zur Herstellung des intergranularen Nanokomposits (49) in das Ausgangsmaterial eingebrachten inerten Nanopartikel (48) aus Platin (Pt) und/oder aus Magnesiumoxid (MgO) und/oder aus Siliziumcarbid (SiC) bestehen.

8. Piezokeramik nach einem der vorhergehenden Ansprüche, **dadurch gekennzeichnet, dass** das Ausgangsmaterial zumindest die zur Herstellung einer Blei-Zirkonat-Titanat (PZT) Piezokeramik (36) erforderlichen Ausgangsverbindungen umfasst.

9. Piezolage (54, 56) aus einer Piezokeramik (46), **gekennzeichnet durch** eine Piezokeramik (46) nach einem der Ansprüche 1 bis 8.

10. Piezoaktor (50) für ein Piezoaktormodul (3) bestehend aus einem aktiven Bereich (51) mit Piezoelementen (53) aus Piezolagen (54) mit dazwischen angeordneten Innenelektroden (55) sowie zumindest einem sich an die Piezoelemente (53) des aktiven Bereichs (51) anschließenden passiven Bereich (52) aus Piezolagen (56), die frei von Innenelektroden (55) sind, **dadurch gekennzeichnet, dass** zumindest die an den aktiven Bereich (51) angrenzenden Piezolagen (56) des passiven Bereichs (52) aus einer Piezokeramik (46) nach einem der Ansprüche 1 bis 8 bestehen, welche einen intrakristallinen Bruchmodus aufweist.

11. Piezoaktor nach Anspruch 10, **dadurch gekennzeichnet, dass** beidseitig des aktiven Bereichs (51) passive Bereiche (52) aus Piezolagen (56) bestehend aus Piezokeramik (46) mit intrakristallinem Bruchmodus anschließen.

12. Piezoaktor nach einem der Ansprüche 10 oder 11, **dadurch gekennzeichnet, dass** zusätzlich zumindest die an den passiven Bereich (52) angrenzenden Piezolagen (54) der Piezoelemente (53) des aktiven Bereichs (51) aus der Piezokeramik (46) mit intrakristallinem Bruchmodus bestehen.

13. Piezoaktor nach einem der Ansprüche 10, 11 oder 12, **dadurch gekennzeichnet, dass** sämtliche Piezolagen (54, 56) des Piezoaktors (50) aus der Piezokeramik (46) mit intrakristallinem Bruchmodus bestehen.

14. Piezoaktor nach einem der Ansprüche 10, 11 oder 12, **dadurch gekennzeichnet, dass** die verbleibenden Piezolagen des Piezoaktors (50) aus einer aus demselben Ausgangsmaterial hergestellten Piezokeramik (36) wie die Piezokeramik (46) mit intrakristallinem Bruchmodus bestehen.

15. Piezoaktormodul (3) umfassend einen Aktorfuß (5) und einen Aktorkopf (4) und mindestens einen dazwischen eingefassten Piezoaktor (20), **gekennzeichnet durch** einen Piezoaktor (50) nach einem der Ansprüche 10 bis 14.

16. Piezoinjektor (1) mit einem Haltekörper (2) und einem in dem Haltekörper (2) angeordneten Piezoaktormodul (3), **gekennzeichnet durch** ein Piezoaktormodul (3) nach Anspruch 15.
